# EUROPÄISCHE PATENTSCHRIFT

(11) **EP 3 874 917 B1**
(45) Veröffentlichungstag und Bekanntmachung des Hinweises auf die Patenterteilung: **22.02.2023**
(21) Anmeldenummer: 19782556.5
(22) Anmeldetag: 01.10.2019
(51) Int. Cl.: H05K 1/02, H01L 25/07, H01L 25/18, H05K 7/14, H05K 1/11, H05K 1/18

(54) **HOCHSTROMSCHALTUNG**
HIGH CURRENT CIRCUIT
CIRCUIT HAUTE INTENSITÉ

(30) Priorität: 30.10.2018 DE 102018127075
(43) Veröffentlichungstag der Anmeldung: 08.09.2021
(73) Patentinhaber: Auto-Kabel Management GmbH, 79688 Hausen i.W. (DE)
(72) Erfinder: KRATZER, Udo, 52080 Aachen (DE); CACCIATORE, David, 47804 Krefeld (DE)
(74) Vertreter: Cohausz & Florack
(86) Internationale Anmeldenummer: PCT/EP2019/076506
(87) Internationale Veröffentlichungsnummer: WO 2020/088868

(56) Entgegenhaltungen:
- WO-A1-2009/068867
- WO-A2-02/057100
- DE-A1-102005 014 413
- US-A1- 2002 162 678

## Beschreibung

Der Gegenstand betrifft eine Hochstromschaltung, insbesondere eine Kraftfahrzeughochstromschaltung, insbesondere einen Hochstromschalter, einen gesteuerten Hochstromwiderstand sowie eine Start-Stopp-Automatikschaltung.

Der stetige Anstieg der Anzahl elektrischer Komponenten in modernen Fahrzeugen bedingt einen zunehmenden Energiebedarf und damit einhergehende hohen Stromstärken. Hierbei treten sehr hohe Schaltströme auf, welche mit Halbleiterschaltern, beispielsweise MOSFETs oder IGBTs geschaltet werden. Durch die hohen Ströme, die mit diesen Halbleiterschaltern geschaltet werden, treten zweierlei Herausforderungen auf. Einerseits muss die Stromtragfähigkeit durch die Schaltung gewährleistet sein, das heißt, dass Ströme von bis zu mehreren 100 A über die Schaltung fließen können müssen. Diese hohe Stromtragfähigkeit verlangt nach großen Leiterquerschnitten, die in der Regel auf Leiterplatten nicht zu realisieren sind. Aufwendige Hochstromleiterplatten mit einem elektrisch leitfähigen Substrat sind bekannt, diese sind jedoch sehr aufwendig in der Herstellung und somit für den Masseneinsatz eher ungeeignet. Andererseits kommt es durch die hohen Stromflüsse zu erheblichen ohmschen Verlusten, deren joulesche Wärme abgeführt werden muss. Die Wärmeableitung ist bei herkömmlichen Leiterplatten gering, da deren Substrate nicht leitend sind und somit auch einen schlechten thermischen Leiter darstellen.

Die US 2002/0162678 A1 betrifft ein elektronisches Gerät mit einem Gehäuse zur Aufnahme eines elektronischen Schaltungssubstrats, auf dem z.B. wärmeerzeugende elektronische Komponenten montiert sind.

Die WO 02/057100 A2 betrifft eine elektrische Heizung für ein Kraftfahrzeug.

Die DE 10 2005 014413 A1 betrifft eine Anordnung zur Wärmeableitung.

Die WO 2009/068867 A1 bezieht sich auf eine Anschlussdose. Anschlussdosen sind in Kraftfahrzeugen als Teil der elektrischen Energieverteilung vorgesehen. Sie verteilen elektrische Energie an elektrische Schaltungen über Kabelbäume, die in der Regel aus einer Vielzahl von einzeln isolierten Drähten zusammen gebündelt, wobei jeder Draht verbindet die Anschlussdose zu elektrischen Schaltung, wie ein Elektromotor, ein Schalter oder eine Lampe.

Ausgehend von diesem Stand der Technik lag dem Gegenstand die Aufgabe zu Grunde, eine Hochstromschaltung zur Verfügung zu stellen, welche unter Verwendung von herkömmlichen Leiterplatten sowohl die Anforderungen an die Stromtragfähigkeit als auch die Anforderung an die Abwärme für Anwendungen mit hohen Strömen, insbesondere in Kraftfahrzeugen genügt.

Diese Aufgabe wird durch eine Hochstromschaltung nach Anspruch 1 gelöst.

Wie eingangs bereits erwähnt, soll die Schaltung mit einer herkömmlichen Leiterplatte realisiert werden. Eine solche Leiterplatte ist aus einem nicht leitenden Substrat, einer auf dem Substrat aufgebrachte Leiterschicht und einer auf der Leiterschicht aufgebrachten Isolationsschicht gebildet. Das Substrat kann ein sogenanntes Prepreg sein. Insbesondere kann das Substrat aus einem Fasermaterial und/oder einem Kunstharz gebildet sein. Substrate für Leiterplatten sind hinlänglich bekannt. Jegliche für Leiterplatten bekannte Substrate, welche nicht leitend sind, können für die gegenständliche Anwendung zum Einsatz kommen.

Auf dem Substrat wird zunächst eine Leiterschicht aufgetragen, die beispielsweise eine Kupferschicht ist. Diese Leiterschicht wird bei herkömmlichen Leiterplatten durch Belichtung und Ätzen so angepasst, dass Leiterbahnen und Kontaktpads auf der Leiterplatte angeordnet sind. Auf die so geätzten Leiterbahnen wird eine Isolationsschicht aufgebracht, wobei Kontaktpads von der Isolation ausgenommen sind. Auch bei der gegenständlichen Leiterplatte sind sowohl Leiterbahnen als auch Kontaktpads vorgesehen.

Bei der gegenständlichen Leiterplatte sind beidseitig jeweils die Isolationsschicht durchbrechende Kontaktpads angeordnet. Diese Kontaktpads sind über leitende Vias durch das Substrat der Leiterplatte hindurch miteinander kontaktiert. Dabei liegen die Vias unmittelbar in der Fläche der Kontaktpads. Die Vias durchbrechen das Substrat im Wesentlichen senkrecht, so dass die Kontaktpads, welche über Vias miteinander verbunden sind, in einer Normalprojektion auf das Substrat unmittelbar übereinander angeordnet sind.

Zur Gewährleistung einer hohen Stromtragfähigkeit bei gleichzeitig guter Wärmeleitung wird vorgeschlagen, dass auf einer ersten Seite der Leiterplatte zumindest ein erstes der Kontaktpads angeordnet ist und auf einer zweiten Seite der Leiterplatte ein erster Halbleiterschalter unmittelbar mit zumindest einem zweiten der Kontaktpads verbunden ist. Der Halbleiterschalter liegt somit unmittelbar auf dem zweiten Kontaktpad und eine elektrische Verbindung zwischen dem ersten Kontaktpad und dem zweiten Kontaktpad erfolgt über die Vias, die zwischen dem ersten und dem zweiten Kontaktpad angeordnet sind. Dadurch ist es möglich, dass eine Verbindung des Halbleiterschalters über das zweite Kontaktpad und die Vias mit dem ersten Kontaktpad ermöglicht ist, ohne das weitere Leiterbahnen benötigt werden. Das bedeutet, dass die auf einander gegenüberliegenden Seiten der Leiterplatte angeordnete Kontaktpads unmittelbar über die Vias verbunden sind und ein Strom von einem Halbleiterschalter über das zweite Kontaktpad und die Vias unmittelbar zu dem ersten Kontaktpad gelangen kann, ohne über dünne Leiterbahnen, welche auf dem Substrat aufgebracht sind, geführt zu werden.

Diese Unmittelbarkeit der Verbindung zwischen der ersten Seite der Leiterplatte und der zweiten Seite der Leiterplatte hat den besonderen Vorteil, dass eine sehr hohe Stromtragfähigkeit gewährleistet ist, da der Strom nicht über dünne Leiterschichten geführt werden muss, sondern unmittelbar durch die Vias fließen kann. Darüber hinaus ist die Kontaktierung von zwei Kontaktpads über Vias eine besonders einfache und massentaugliche Methode zur Herstellung von Leiterplatten, so dass sich die Leiterplatten auch in großer Stückzahl verlässlich herstellen lassen.

Darüber hinaus ist es möglich, unmittelbar auf dem Kontaktpad und/oder unmittelbar auf dem Halbleiterschalter einen Kühlkörper oder ein Flachteil aufzubringen.

Gemäß einem Ausführungsbeispiel wird vorgeschlagen, dass die Flächen des ersten und zweiten Kontaktpads auf den beiden Seiten der Leiterplatte übereinander angeordnet sind. In einer Normalprojektion auf die Leiterplatte überdecken sich somit die beiden auf einander gegenüberliegenden Seiten der Leiterplatte angeordneten Kontaktpads. Insbesondere ist die Größe der Kontaktpads im Wesentlichen identisch. Die Kontaktpads sind dabei größer als herkömmliche Kontaktpads, in dem sie Flächen einnehmen, die ein Vielfaches, insbesondere um einen Faktor vom mehr als 10, bevorzugt mehr als 50 größer sind, als die Flächen von Kontaktpins der Halbleiterschalter, so dass die Kontaktpads eine hohe Stromtragfähigkeit aufweisen.

Gemäß einem Ausführungsbeispiel wird vorgeschlagen, dass auf der ersten Seite der Leiterplatte ein Flachteil unmittelbar mit dem ersten der Kontaktpads verbunden ist. Das Flachteil kann unmittelbar auf dem ersten Kontaktpad aufliegen und insbesondere vollflächig mit dem Kontaktpad verbunden sein. Das Kontaktpad auf der ersten Seite der Leiterplatte kann eine Fläche einnehmen, die sich über die Fläche von Anschlusspins mehrerer Halbleiterschalter erstreckt. So ist es möglich, dass auf der zweiten Seite der Leiterplatte zwei oder mehr Halbleiterschalter elektrisch parallel zueinander über zweite Kontaktpads mit dem ersten Kontaktpad verbunden sind und das erste und/oder zweite Kontaktpad vollflächig ist und ein einziges elektrisches Potenzial aufweist.

Auch ist es möglich, dass das Kontaktpad vollflächig metallisch beschichtet ist, insbesondere mit einer Zinnschicht. Über das gesamte Kontaktpad sind somit zum einen ein Stromfluss und zum anderen eine Wärmeübertragung möglich. Ist das Flachteil unmittelbar mit dem ersten Kontaktpad verbunden und ist das erste Kontaktpad großflächig, so ist eine sehr gute Wärmeübertragung von dem Kontaktpad auf das Flachteil möglich. Das Flachteil kann unmittelbar auf das erste Kontaktpad aufgebracht, insbesondere verlötet werden. Dabei kann das Flachteil auf das Kontaktpad aufgelegt werden und beispielsweise mittels Reflow-Löten mit dem Kontaktpad verbunden werden. Das im Bereich der Fläche des Flachteils liegende Kontaktpad kann vollflächig, ohne Unterbrechung sein, so dass ein möglichst großer Wärmeübertrag von dem Kontaktpad auf das Flachteil möglich ist.

Gemäß einem Ausführungsbeispiel wird vorgeschlagen, dass auf der zweiten Seite der Leiterplatte zumindest ein Kontaktpin des Halbleiterschalters unmittelbar mit dem zweiten der Kontaktpads verbunden ist. Ein Halbleiterschalter kann auch mit allen Kontaktpins eines Leistungsanschlusses mit dem zweiten Kontaktpad verbunden sein. Dabei können alle Kontaktpins auf dem gleichen elektrischen Potenzial liegen und das Kontaktpad kann als einzige Fläche mit diesen Kontaktpins verbunden sein. Auch hierdurch wird eine großflächige Wärmeableitung und Kontaktierung mit den Kontaktpins des Halbleiterschalters ermöglicht. Die Halbleiterschalter können sowohl zwei Leistungsanschlüsse als auch einen Schaltanschluss aufweisen. Leistungsanschlüsse sind beispielsweise Source und Drain, ein Schaltanschluss kann Gate sein.

Wie bereits erläutert, können ein oder mehrere Haltleiterschalter mit einem ersten Leistungsanschluss unmittelbar mit dem zweiten Kontaktpad verbunden sein. Auf der zweiten Seite der Leiterplatte kann darüber hinaus ein viertes Kontaktpad sein, welches mit zweiten Kontaktpins des Halbleiterschalters verbunden ist. Dabei ist es möglich, dass auf der zweiten Seite der Leiterplatte zwei Halbleiterschalter in Reihe zueinander geschaltet sind und die miteinander in Reihe verschalteten Halbleiterschalter über das vierte Kontaktpad unmittelbar verbunden sind. Die Halbleiterschalter können auf der zweiten Seite der Leiterplatte aufliegen und einerseits mit Kontaktpins eines Leistungsanschlusses auf zweiten Kontaktpads angeordnet sein und mit den dazu korrespondierenden Kontaktpins eines Leistungsanschlusses auf einem vierten Kontaktpad verbunden sein. Das vierte Kontaktpad stellt einen elektrischen Kurzschluss zwischen den beiden Halbleiterschaltern bzw. den Kontaktpins jeweils eines Leistungsanschlusses her. Über dieses vierte Kontaktpad fließt der gesamte zu schaltende Strom.

Korrespondierend zu dem vierten Kontaktpad kann auf der ersten Seite der Leiterplatte ein drittes Kontaktpad vorgesehen sein. Dieses Kontaktpad kann isoliert zu den ersten Kontaktpads sein. Das vierte Kontaktpad kann mit dem dritten Kontaktpad über Vias kontaktiert sein. Über das vierte Kontaktpad kann somit einerseits ein Strom fließen und andererseits kann das vierte Kontaktpad zur Wärmeübertragung genutzt werden.

Der Aufbau der Hochstromschaltung kann beispielsweise derart sein, dass auf der zweiten Seite der Leiterplatte die Halbleiterschalter angeordnet sind und auf der ersten Seite der Leiterplatte die Flachteile. So ist es beispielsweise möglich, dass ein erstes Flachteil mit einem ersten Kontaktpad vollflächig verbunden ist. Dieses erste Kontaktpad kann über Vias mit einem zweiten Kontaktpad elektrisch kontaktiert sein.

An dem zweiten Kontaktpad kann zumindest ein erster Halbleiterschalter mit seinem Leistungsanschluss angeschlossen sein. Der dazu korrespondierende zweite Leistungsanschluss des zumindest einen ersten Halbleiterschalters kann mit einem vierten Kontaktpad kontaktiert sein, welches elektrisch isoliert zu dem zweiten und dem ersten Kontaktpad ist.

Auf der dem dritten Kontaktpad gegenüberliegenden Seite der Leiterplatte kann ein viertes Kontaktpad angeordnet sein, welches mit dem dritten Kontaktpad über Vias verbunden ist. Auf dem dritten Kontaktpad kann ein Flachteil vollflächig, bevorzugt wie das erste Flachteil an dem ersten Kontaktpad, befestigt sein. Über dieses Flachteil lässt sich eine gute Wärmeabfuhr realisieren.

Ausgehend von dem vierten Kontaktpad kann zumindest ein weiterer Halbleiterschalter spiegelbildlich zu dem zumindest einem ersten Halbleiterschalter angeordnet sein, wobei der zumindest eine weitere Halbleiterschalter zunächst mit seinem Leistungsanschluss an dem vierten Kontaktpad angeordnet sind und mit seinem dazu korrespondierenden Leistungsanschluss an einem sechsten Kontaktpad angeordnet sein.

Dem sechsten Kontaktpad gegenüber liegend kann entsprechend dem ersten Kontaktpad ein fünftes Kontaktpad angeordnet sein. Das fünfte und sechste Kontaktpad können entsprechend dem ersten und zweiten Kontaktpad, insbesondere identisch hierzu, gebildet sind. An dem fünften Kontaktpad kann wiederum ein Flachteil angeordnet sein, welches wie das erste Flachteil an dem ersten Kontaktpad angeordnet ist. Die an dem ersten und fünften Kontaktpad angeordneten Flachteile können als Anschlussfahne gebildet sein.

Die Flachteile können aus Kupfer, einer Kupferlegierung, Aluminium oder einer Aluminiumlegierung gebildet sein. Auch ist es möglich, dass die Flachteile bimetallisch gebildet sind, wobei die mit den Kontaktpads in Verbindung stehenden Bereiche aus einer Kupferlegierung gebildet sind und die aus der Fläche der Leiterplatte heraus ragende Anschlussfahnen aus einer Aluminiumlegierung gebildet sein können. Eine hierzu spiegelverkehrte Anordnung von Kupferlegierung und Aluminiumlegierung ist ebenfalls möglich.

Auch ein sandwichartiger Aufbau derart, dass die Leiterplatte zwischen den Halbleiterschaltern und den Flachteilen angeordnet ist, wobei auf einer Seite der Leiterplatte die Halbleiterschalter angeordnet sind und auf der anderen Seite der Leiterplatte die Flachteile, ist bevorzugt.

Gemäß einem Ausführungsbeispiel ist es auch möglich, dass auf der ersten Seite der Leiterplatte entsprechend der zweiten Seite der Leiterplatte, ein zweiter Halbleiterschalter unmittelbar mit dem ersten Kontaktpad verbunden ist. Dies ist insbesondere dann möglich, wenn die Halbleiterschalter ihre Leistungsanschlüssen auf ihren breiten Oberflächen aufweisen. Die Halbleiterschalter sind in der Regel quaderförmig. Zwei einander gegenüber liegende, breite Oberflächen können mit jeweils einem Leistungsanschluss (Source/Drain) versehen sein. Diese Leistungsanschlüsse können großflächig, insbesondere vollflächig auf den breiten Oberflächen der Halbleiterschalter angeordnet sein. Die Halbleiterschalter können mit ihren breiten Oberflächen vollflächig auf den Kontaktpads angeordnet sein und insbesondere an diesen verlötet sein.

Die Leiterplatte ist bevorzugt sandwichartig zwischen zwei Halbleiterschaltern eingefasst. Die Kontaktpads sind über eine Mehrzahl an Vias miteinander verbunden. Ein Strom fließt somit unmittelbar über die Vias zwischen den Halbleiterschaltern und eine Leiterbahn ist nicht notwendig.

Bei den beiden zuvor beschriebenen Varianten sei angemerkt, dass ein Schaltanschluss (Gate) über jeweils zumindest einen separaten Kontaktpin des Halbleiterschalters ansteuerbar ist. Die Ansteuerung des Gate-Kontakts kann dabei über eine Leiterbahn, die auf der Leiterplatte angeordnet ist, realisiert sein. Über den Gate-Anschluss fließt nur ein Schaltstrom, so dass dieser über Leiterbahnen geführt sein kann. Die ersten bis sechsten Kontaktpads sind isoliert von dem Gate-Anschluss und der jeweiligen Leiterbahn, die zu dem Kontaktpin des Schaltanschlusses des Halbleiterschalters führt.

Für eine gute Wärmeleitung wird vorgeschlagen, dass der erste und/oder zweite Halbleiterschalter auf einer den Kontaktpads abgewandten Seite unmittelbar mit einem Flachteil verbunden ist. Die zweite Seite des Halbleiterschalters ist insbesondere auch eine breite Oberfläche, auf der ein Leistungsanschluss des Halbleiterschalters angeordnet ist. Es ist möglich, dass einer oder beide der einander gegenüberliegenden Halbleiterschalter jeweils mit einer breiten Oberfläche auf jeweils einem der Kontaktpads und mit der jeweils anderen breiten Oberfläche mit jeweils einem Flachteil verbunden sind.

Wie erläutert, sind die Kontaktpads unmittelbar über Vias miteinander verbunden, ohne dass Leiterbahnen dazwischen liegen. Dies führt dazu, dass gemäß einem Ausführungsbeispiel die Halbleiterschalter miteinander ausschließlich über die Vias verbunden sind. Die Halbleiterschalter sind mit ihren Kontaktpins oder Kontaktflächen der Leistungsanschlüsse unmittelbar auf den Kontaktpads angeordnet, welche über die Vias unmittelbar miteinander verbunden sind. Somit erfolgt ein Stromfluss zwischen den Halbleiterschaltern unmittelbar über die Vias.

Gemäß einem Ausführungsbeispiel wird vorgeschlagen, dass auf der ersten Seite der Leiterplatte ein Kontaktpad eine Fläche hat, die zumindest die Fläche aller Anschlüsse des zumindest einen auf der zweiten Seite der Leiterplatte kontaktierten Halbleiterschalters hat. Der zumindest eine Halbleiterschalter auf der zweiten Seite der Leiterplatte kann mit zwei Kontaktpads kontaktiert sein, wobei ein erstes Kontaktpad für die Kontaktpins des Leistungsanschlusses des Halbleiterschalters vorgesehen ist und ein zweites, hierzu kleineres Kontaktpad für den Kontaktpin des Schaltanschlusses. Die Kontaktpads von Leistungsanschlüssen und Schaltanschlüssen mehrerer Halbleiterschalter können nebeneinander, zueinander isoliert auf der zweiten Seite der Leiterplatte angeordnet sein. Auf der ersten Seite der Leiterplatte kann hierzu korrespondierend ein vollflächiges Kontaktpad über die gesamte Fläche liegen. Die Kontaktpads der Leistungsanschlüsse auf der zweiten Seite der Leiterplatte sind über eine Vielzahl an Vias mit dem Kontaktpad auf der ersten Seite der Leiterplatte verbunden.

Gemäß einem Ausführungsbeispiel wird vorgeschlagen, dass das Flachteil vollflächig mit dem zumindest einen Kontaktpad verbunden ist. Ein Flachteil kann auf dem ersten Kontaktpad, dem dritten Kontaktpad und/oder dem fünften Kontaktpad angeordnet sein. Dabei liegt das Flachteil vollflächig auf dem jeweiligen Kontaktpad und ist insbesondere vollflächig mit dem jeweiligen Kontaktpad verlötet, so dass das Flachteil einerseits einen Stromfluss ermöglicht und andererseits einen guten Wärmetransport.

Gemäß einem Ausführungsbeispiel wird vorgeschlagen, dass auf der ersten Seite der Leiterplatte zumindest drei voneinander isolierte Kontaktpads angeordnet sind. Dies können das erste Kontaktpad, das dritte Kontaktpad und das fünfte Kontaktpad sein. Auf der zweiten Seite der Leiterplatte sind hierzu korrespondierende Kontaktpads, insbesondere zweite, vierte und sechste Kontaktpads vorgesehen. Die Kontaktpads auf den beiden Seiten der Leiterplatte sind ausschließlich über Vias miteinander verbunden. An den Kontaktpads der zweiten Seite der Leiterplatte sind die Leistungsanschlüsse der Halbleiterschalter angeordnet. Jedes der Kontaktpads auf der ersten Seite der Leiterplatte ist vollflächig mit einem Flachteil bestückt.

Gemäß einem Ausführungsbeispiel wird vorgeschlagen, dass auf der zweiten Seite der Leiterplatte für jeweils einen Halbleiterschalter zumindest ein Kontaktpad für jeweils einen von zwei Leistungsanschlüssen angeordnet ist. Die Halbleiterschalter können eingangsseitig, beispielsweise an einem ersten Leistungsanschluss mit voneinander getrennten Kontaktpads verschaltet sein und hierzu parallel können Kontaktpads für die Schaltanschlüsse vorgesehen sein. Hierdurch ist es möglich, Schaltanschlüsse an Kontaktpins zu führen, die unmittelbar neben den Kontaktpins der Leistungsanschlüsse des Halbleiterschalters liegen.

Auf der anderen Seite des Halbleiterschalters, an dem lediglich Leistungsanschlüsse an Kontaktpins geführt sind, können alle Kontaktpins auf einem vollflächigen Kontaktpad aufliegen. Somit ist es möglich, dass ein einziges Kontaktpad, insbesondere das vierte Kontaktpad eine Mehrzahl von Leistungsanschlüssen von Halbleiterschaltern miteinander verbindet. Das Kontaktpad ist dabei vollflächig und ununterbrochen.

Um einen guten Stromtransport zu ermöglichen, insbesondere um die Stromtragfähigkeit der Schaltung zu gewährleisten, ist eine Vielzahl von Vias pro Kontaktpad vorgesehen. Die Vias pro Kontaktpad kann eine Zahl von 10, insbesondere auch von 30 überschreiten. So ist es möglich, dass 40-50 Vias pro Kontaktpad vorgesehen sind, um einen ausreichend hohen Stromfluss zu ermöglichen.

Gemäß einem Ausführungsbeispiel wird vorgeschlagen, dass zumindest eines der Flachteile aus der Fläche der Leiterplatte herausgeführt ist und eine Anschlussfahne für einen Energieleiter bildet. In einer Normalprojektion, das heißt in einer Draufsicht der Leiterplatte, kann das Flachteil aus der Fläche der Leiterplatte herausgeführt sein, um somit besonders einfach eine Kontaktierung mit einer Anschlussfahne zu ermöglichen.

Gemäß einem Ausführungsbeispiel wird vorgeschlagen, dass die Leiterschicht zwischen zwei Kanten der Leiterplatte vollständig durchtrennt ist und die Leiterplatte in zwei Bereiche aufteilt, wobei in einem ersten Bereich eine Hochstromschaltung nach einem der vorangehenden Ansprüche angeordnet ist und in einem zweiten Bereich eine Logikschaltung angeordnet ist. Somit ist es möglich, auf einer einzigen Leiterplatte sowohl eine Leistungsschaltung als auch eine Logikschaltung unterzubringen. Durch die Auftrennung der Leiterschicht besteht auf de Leiterplatte keine elektrisch leitende Verbindung zwischen diesen beiden Bereichen der Leiterplatte. Dies führt dazu, dass ein Wärmetransport von dem ersten Bereich zu dem zweiten Bereich stark behindert ist, da das Substrat der Leiterplatte ein schlechter Wärmeleiter ist. Dies ermöglicht es, auf der einen Seite die Leiterplatte im Bereich der Hochstromschaltung mit Strömen zu belasten, die zu Temperaturen führen, die für Logikbausteine ungeeignet sind. So kann die Hochstromschaltung beispielsweise bis über 80°C erwärmen ohne dass Logikbausteine auf der anderen Seite davon negativ beeinflusst werden, da eine wärmetechnische Entkoppelung der beiden Bereiche der Leiterplatte durch das Auftrennen der Leiterschicht gewährleistet ist.

Nachfolgend wird der Gegenstand anhand einer Ausführungsbeispiele zeigenden Zeichnung näher erläutert. In der Zeichnung zeigen:
- Fig. 1: einen Schichtaufbau einer Leiterplatte;
- Fig. 2: eine Draufsicht auf eine erste Seite der Leiterplatte;
- Fig. 3: eine Draufsicht auf eine zweite Seite der Leiterplatte;
- Fig. 4a, b: Ansichten eines ersten Halbleiterschalters;
- Fig. 5a, b: Ansichten eines zweiten Halbleiterschalters;
- Fig. 6: eine bestückte zweite Seite der Leiterplatte mit Halbleiterschalter;
- Fig. 7a, b: Ansichten von Flachteilen;
- Fig. 8: eine Draufsicht auf eine bestückte erste Seite mit Flachteilen;
- Fig. 9: eine Schnittansicht durch eine bestückte Schaltungsanordnung;
- Fig. 10: eine Draufsicht auf eine zweite Seite gemäß einem Ausführungsbeispiel;
- Fig. 11: die Seite gemäß Fig. 1 mit Halbleiterschaltern bestückt;
- Fig. 12: die bestückte Halbleiterschaltung gemäß Fig. 11 mit einem Flachteil;
- Fig. 13: eine zu der Fig. 11 korrespondierende erste Seite;
- Fig. 14: eine bestückte erste Seite gemäß Fig. 13;
- Fig. 15: eine mit einem Flachteil abgedeckte, bestückte Schaltung gemäß Fig. 14;
- Fig. 16: eine Schnittansicht durch eine bestückte Schaltungsanordnung.

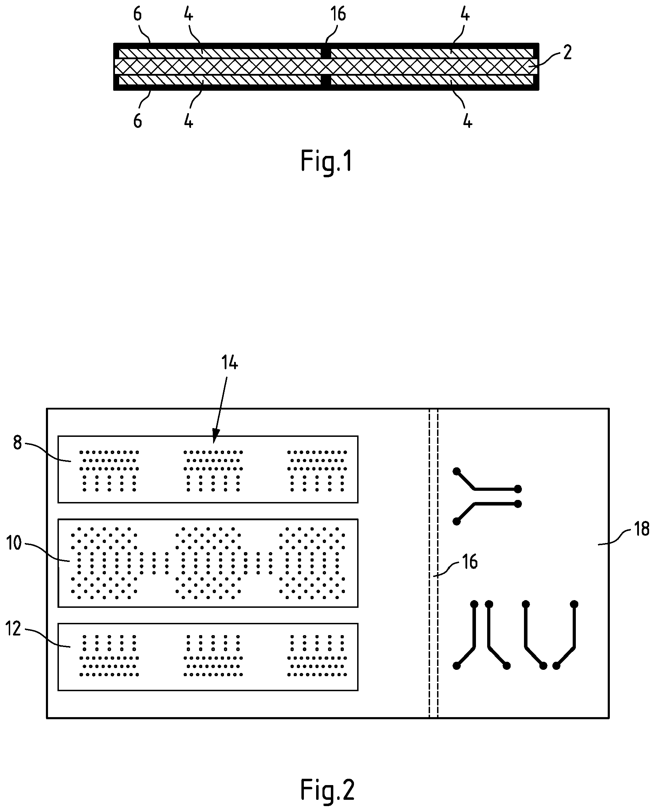

Fig. 1 zeigt einen Querschnitt einer Leiterplatte mit einem Substrat 2. Das Substrat 2 kann ein faserverstärktes Epoxid Harz sein. Das Substrat 2 ist insbesondere nicht leitend. Das Substrat 2 ist dabei ein für Leiterplatten herkömmliches Substrat.

Auf dem Substrat 2 ist eine Leiterschicht 4 aufgebracht. Die Leiterschicht 4 ist insbesondere eine Kupferschicht. Die Leiterschicht 4 ist üblicherweise dünner als 1mm und wird bei der Produktion von gedruckten Schaltungen durch Belichten und Ätzen in die gewünschte Topologie gebracht. Die Leiterschicht 4 ist mit einer Isolationsschicht 6 abgedeckt. Die Isolationsschicht 6 kann beispielsweise ein Lötstopplack sein. An Stellen, an denen die Leiterschicht 4 kontaktiert sein soll, kann die Isolationsschicht 6 entfernt sein und/oder die Leiterschicht 4 kann dort aus der Isolationsschicht 6 herausgeführt sein. Hierdurch kann beispielsweise auf der Leiterschicht 4 ein Kontaktpad aufgebracht sein. Der Aufbau der Leiterplatte gemäß Fig. 1 ist ein herkömmlicher Aufbau, wie er bei Standard Leiterplatten zum Einsatz kommt.

Mit Hilfe eines solchen Standardaufbaus einer Leiterplatte ist es möglich, eine gegenständliche Schaltungsanordnung zu realisieren. Hierzu wird, wie in der Fig. 2 gezeigt ist, auf einer ersten Seite der Leiterplatte zumindest ein großflächiges Kontaktpad 8 angeordnet. Fig. 2 zeigt ein erstes Kontaktpad 8, ein drittes Kontaktpad 10 sowie ein fünftes Kontaktpad 12. Die Nummerierung der Kontaktpad 8, 10,12 soll lediglich das Lesen vereinfachen, wobei die Nummerierung nicht so zu verstehen ist, dass ein zweites Kontaktpad zwingend ein erstes Kontaktpad benötigt, ein drittes Kontaktpad zwingend erste und zweite Kontaktpads, ein viertes Kontaktpad dritte bis erste Kontaktpads und so weiter.

Die Kontaktpads 8 bis 12 sind auf der Leiterschicht 4 auf der ersten Seite der Leiterplatte aufgebracht, insbesondere durch metallische Beschichtung der Leiterschicht 4 in einer Öffnung der Isolationsschicht 6. Die Kontaktpads 8-12 sowie alle weiteren hier genannten Kontaktpads sind vom Aufbau her bevorzugt identisch, wobei sie aus der Leiterschicht 4 und einer darauf aufgebrachten metallischen Beschichtung gebildet sind. Die metallische Beschichtung kann beispielsweise eine Verzinnung sein. Die metallische Beschichtung schließt vorzugsweise planparallel mit der Isolationsschicht 6 ab, wobei Abweichungen von wenigen µm möglich sind.

Die Kontaktpads 8, 10, 12 sind durchsetzt mit Vias 14, wobei die Vias 14 Bohrungen durch die Leiterschichten 4 und das Substrat 2 sein können. Die Vias 14 durchstoßen dabei das Substrat 2 vollständig und sind zumindest teilweise metallisch oder metallisch beschichtet. Die Vias 14 sind elektrisch leitend. Hierdurch stellen die Vias 14 einen elektrischen Kurzschluss zwischen den einander gegenüberliegenden Leiterschichten 4 und mithin den auf den Leiterschichten 4 aufgebrachten Kontaktpads. Durch Auftrennen der Leiterschicht 4 wird erreicht, dass die Kontaktpads 8-12 sowie auch die nachfolgend genannten Kontaktpads jeweils auf einer Seite der Leiterplatte voneinander isoliert sind, über die Vias aber auf einander gegenüberliegenden Seiten der Leiterplatte miteinander kurzgeschlossen sind. Die Kontaktpads 8-12 sowie auch die nachfolgenden Kontaktpads sind großflächig und eignen sich zum Aufbringen eines großflächigen Kontaktteils.

In der Fig. 2 ist weiter gezeigt, dass die Leiterschicht 4 an einer Trennstelle 16 vollständig aufgetrennt ist, so dass die Leiterplatte in zwei Bereiche unterteilt ist. Diese zwei Bereiche sind einerseits der Bereich mit den Kontaktpads und andererseits ein Bereich mit einer Logikschaltung 18. Die Logikschaltung 18 ist durch die Trennstelle 16 von der Hochvoltschaltung, wie sie auf der Leiterplatte durch die Kontaktpads realisiert werden wir thermisch abgekoppelt. Das Vorsehen der Trennstelle 16 sowie der Logikschaltung 18 ist fakultativ und vorliegend der Vollständigkeit halber erwähnt.

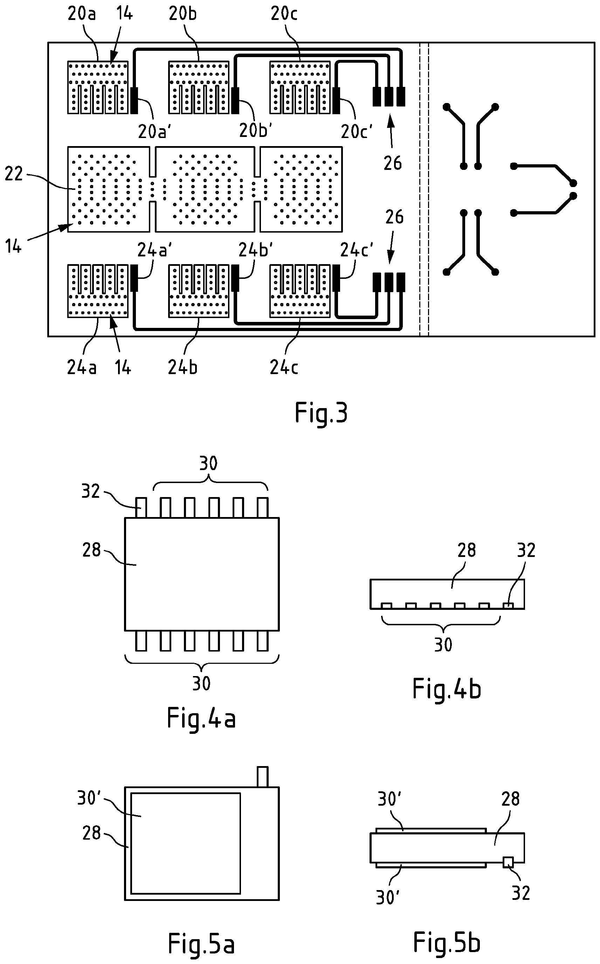

Fig. 3 zeigt eine zweite Seite einer Leiterplatte gemäß Fig. 1 deren Aufbau zu dem Aufbau der Leiterplatte gemäß Fig. 2 korrespondiert. Zu erkennen sind zweite Kontaktpads 20a-c, ein viertes Kontaktpad 22 sowie sechste Kontaktpads 24a-c. Die zweiten Kontaktpads 20a-c können über die Leiterschicht 4 miteinander kurzgeschlossen sein. Die Kontaktpads 20a-c, 22 sowie 24a-c sind gegeneinander isoliert, in dem die Leiterschicht 4 entsprechend aufgetrennt ist. Zu erkennen sind wiederum die Vias 14, die die jeweiligen Kontaktpads 20, 22, 24 durchsetzen.

Ferner ist zu erkennen, dass die Kontaktpads 20a-c sowie die Kontaktpads 24a-c zungenartige Anschlussbereiche aufweisen. Dies ist fakultativ, da an Stelle der zungenartigen Anschlussbereiche auch vollflächige Anschlussbereiche vorgesehen sein können. Die entsprechenden Anschlussbereiche dienen zum Anschluss eines ersten Leistungsanschlusses eines Halbleiterschalters, wie nachfolgend gezeigt werden wird. An den Kontaktpads 20a-c, 22, 24 werden Leistungsanschlüsse von Halbleiterschaltern angebracht, insbesondere aufgelötet, wie nachfolgend gezeigt werden wird.

Zum Schalten der Halbleiterschalter ist zusätzlich zu den Kontaktpads 20a-c, 24a-c jeweils ein Kontaktpad 20a', 20b', 20c', 24a', 24b', 24c' vorgesehen. Diese zusätzlichen Kontaktpads 20a`-24c` dienen zum Anschluss eines Schaltanschlusses eines Halbleiterschalters. Die Kontaktpads 20a'-24c' sind gegenüber allen anderen Kontaktpads elektrisch isoliert und können über Schaltanschlüsse 26 gemeinsam oder getrennt voneinander geschaltet werden. Hierdurch lässt sich eine Gruppe von Halbleiterschaltern gemeinsam oder jeder einzelne Halbleiterschalter individuell ansteuern.

Fig. 4a, b zeigen einen Halbleiterschalter 28 in einer Draufsicht sowie in einer Seitenansicht. Der Halbleiterschalter 28 verfügt über Kontaktpins 30, die für einen Leistungsanschluss gedacht sind, sowie zumindest einen Kontaktpin 32 für einen Schaltanschluss. In der Fig. 4b ist zu erkennen, dass der Halbleiterschalter 28 in SMDbauweise aufgebaut ist, so dass er unmittelbar mit seinen Kontaktpins 30, 32 auf die Kontaktpads 8-12, 20-24 aufgesetzt werden kann. Der Halbleiterschalter 28 ist beispielsweise ein MOSFET oder IGBT.

Fig. 5a, b zeigt einen weitere Bauweise eines Halbleiterschalters 28, bei dem auf einander gegenüber liegenden breiten Oberflächen des Halbleiterschalters 28 Kontaktflächen 30' vorgesehen sind, die die Leistungsanschlüsse bilden. Ein Kontaktpin 32 bildet den Schaltanschluss. Diese großflächigen Kontaktflächen 30' ermöglichen eine großflächige Kontaktierung der Leistungsanschlüsse und somit einen hohen Leistungsfluss durch den Halbleiterschalter 28.

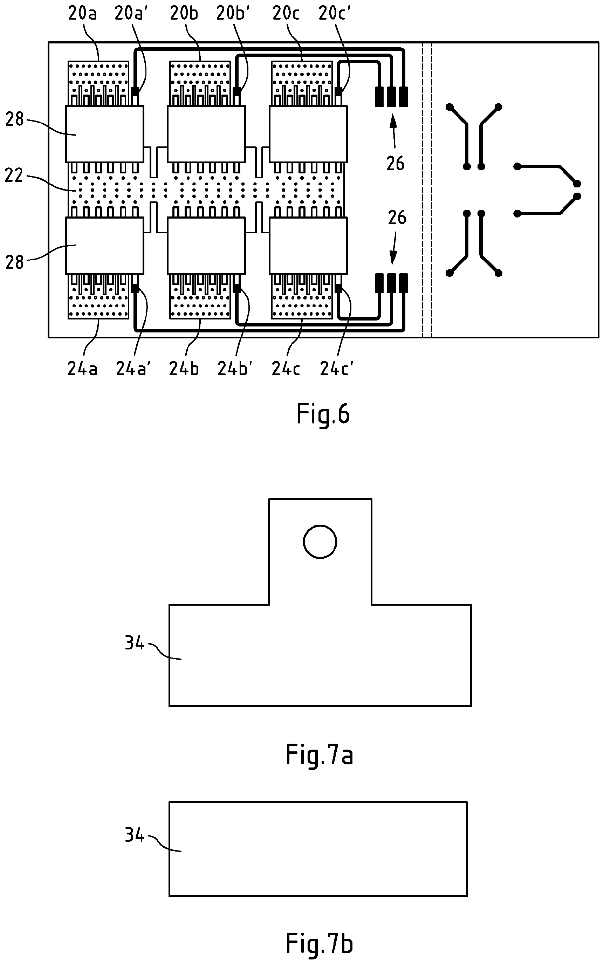

Ein Halbleiterschalter 28 gemäß der Fig. 4 ist auf die in Fig. 3 gezeigt zweite Seite der Leiterplatte aufgebracht, wie in der Fig. 6 gezeigt ist. Zu erkennen ist, dass die Kontaktpins 30 einerseits mit den Kontaktpads 20a, b, c kontaktiert sind und andererseits mit dem Kontaktpad 22. Die jeweiligen Kontaktpins 32 sind mit den jeweiligen Kontaktpads 20a'-c' und mithin dem Schaltanschluss 26 verbunden. Ferner sind Halbleiterschalter 28 mit ihren Kontaktpins 30 einerseits mit den Kontaktpads 24a-c und andererseits mit dem Kontaktpad 22 verbunden. Die jeweiligen Kontaktpins 32 sind mit den jeweiligen Kontaktpads 24a'-c' und mithin dem Schaltanschluss 26 verbunden. Somit sind die Leistungsanschlüsse der Halbleiterschalter 28 jeweils über die Kontaktpads 20a-c sowie 24a-c und dem Kontaktpad 22 verbunden.

Mit Hilfe der Halbleiterschalter 28 kann somit eine Verbindung zwischen den Kontaktpads 20a-c und dem Kontaktpad 22 sowie dem Kontaktpad 22 und den Kontaktpads 24a-c abhängig von deren Schaltzustand hergestellt werden.

Die Halbleiterschalter 28 können mit ihren Kontaktpins 30, 32 aufgelötet sein.

Zum Anschluss der Schaltung gemäß Fig. 6 an Kabel sind Flachteile gemäß der Fig. 7 vorgesehen. Hierbei ist einerseits ein Flachteil 34 gemäß Fig. 7a und ein Flachteil 34 gemäß Fig. 7b vorgesehen. Mit Hilfe des Flachteils 34 gemäß Fig. 7a, welches als Anschlussfahne gebildet ist, kann ein externer Anschluss an die Schaltung ermöglicht werden. Ein Flachteil 34 gemäß Fig. 7b kann als Kühlkörper genutzt werden.

Die Flachteile gemäß Fig. 7a, b werden auf die Schaltung gemäß der Fig. 2 aufgebracht, insbesondere vollflächig aufgelötet. Dabei wird auf das erste Kontaktpad 8 sowie das fünfte Kontaktpad 12 jeweils ein Flachteil 34, welches gemäß Fig. 7a als Anschlussfahne gebildet ist aufgebracht. Auf das Kontaktpad 12 wird ein Flachteil 34 als Kühlkörper aufgebracht. Die Flachteile 34 werden dabei insbesondere vollflächig auf die Kontaktpads 8-12 aufgebracht, insbesondere aufgelötet.

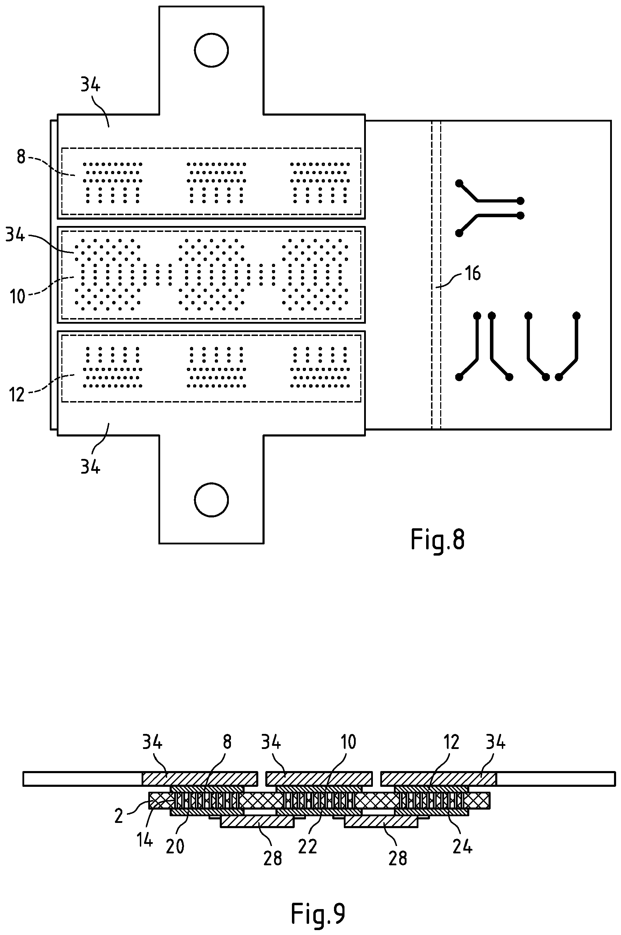

Der Aufbau der Schaltung im bestückten Zustand ist in der Fig. 9 dargestellt. Fig. 9 zeigt, dass durch das Substrat 2 die Vias 14 hindurchgehen und dabei die Kontaktpads 8 und 20, 10 und 22 sowie 12 und 24 miteinander kurzschließen. Ein Stromfluss erfolgt über das Flachteil 34 zu dem Kontaktpad 8 und von dort über die Vias 14 zu dem Kontaktpad 20. Ist der linke Halbleiterschalter 28 geschlossen, so fließt der Strom von dem Kontaktpad 20 über den Halbleiterschalter 28 zu dem Kontaktpad 22. Ist der rechte Halbleiterschalter 28 geschlossen, so fließt der Strom weiter von dem Kontaktpad 22 zu dem Kontaktpad 24 und von dort über die Vias 14 zu dem Kontaktpad 12 und abschließend auf das Flachteil 34.

Das mittlere Flachteil 34, welches auf dem Kontaktpad 10 aufgebracht ist, dient als Kühlkörper. Über die Vias 14 kann ein Wärmetransport von dem Kontaktpad 22 zu dem Kontaktpad 10 erfolgen und das Flachteil 34 kann als zusätzlicher Kühlkörper dienen. Dies ist insbesondere im Falle von hohen Strömen sinnvoll, welche in automotiven Anwendungen durchaus möglich sind.

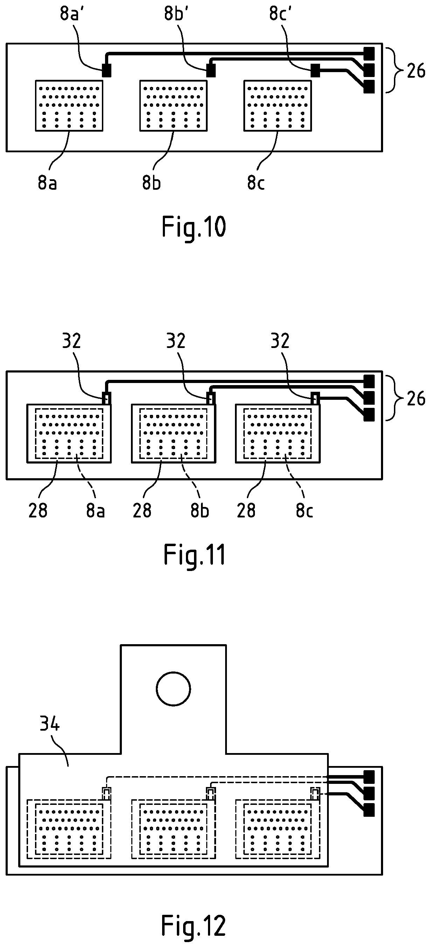

Die Fig. 10-16 zeigen ein weiteres Ausführungsbeispiel, bei dem die Leiterplatte sandwichartig zwischen zwei Flachteilen liegt. Fig. 10 zeigt eine erste Seite einer Leiterplatte mit Kontaktpads 8a-c für einen Leistungsanschluss jeweils eines Halbleiterschalters 28 sowie Kontaktpads 8a'-c' für einen Schaltanschluss jeweils eines Halbleiterschalters 28. Die Kontaktpads 8a-c können miteinander kurzgeschlossen sein oder voneinander isoliert, wohingegen die Kontaktpads 8a'-c' voneinander und gegenüber den Kontaktpads 8a-c isoliert sind und auf einen Schaltanschluss 26 geführt sind.

In der Fig. 11 ist gezeigt, dass die Halbleiterschalter 28 mit ihren Anschlüssen 30' vollflächig auf die Kontaktpads 8a-c aufgesetzt sind und mit diesen verbunden sind. Über Kontaktpins 32 sind die Halbleiterschalter 28 mit den Kontaktpads 8a'-c' verbunden. Die Halbleiterschalter 28 haben einen Aufbau gemäß der Fig. 5. Auf diese Halbleiterschalter 28 wird anschließend ein Flachteil 34 aufgesetzt, wie in der Fig. 12 zu erkennen ist.

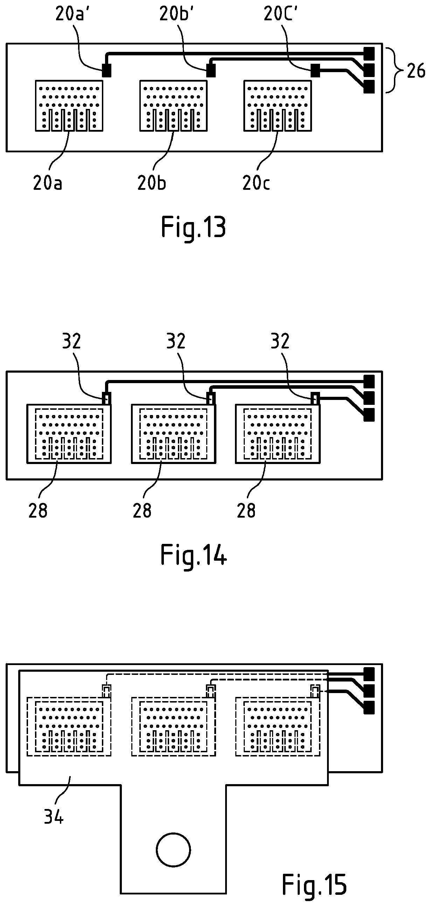

Auf der anderen Seite des Substrats 2 befindet sich ein entsprechender Aufbau mit Kontaktpads 20a-c und 20a`-c` wie in der Fig. 13 gezeigt. Auch hier werden Halbleiterschalter 28 mit ihren Leistungsanschlüssen 30' an die Kontaktpads 20a-c und mit ihren Schaltanschlüssen 32 an die Kontaktpins 20a'-c' angeschlossen, wie in der Fig. 14 gezeigt ist. Anschließend wird auch hier ein Flachteil 34 vollflächig auf die Halbleiterschalter 28, wie in der Fig. 15 gezeigt ist, aufgesetzt.

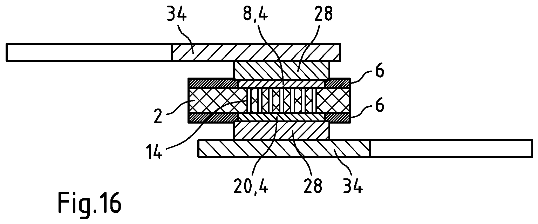

Fig. 16 zeigt einen Querschnitt durch einen solchen sandwichartigen Aufbau. Zwischen den Flachteilen 34 sind sandwichartig die Halbleiterschalter 28 mit ihren Anschlüssen 30' auf den Kontaktpads 8, 20 angeordnet, welche auf den beiden Leiterschichten 4 aufgebracht sind. Die Kontaktpads 8-20 sind über die Vias 14 miteinander kurzgeschlossen. Ein Stromfluss erfolgt über das Flachteil 4, den Halbleiterschalter 28, das Kontaktpad 8, die Vias 14, das Kontaktpad 20 und den Halbleiterschalter 28 zu dem Flachteil 34. Durch die Vias 14 ist ein unmittelbarer Kurzschluss zwischen den Halbleiterschaltern 28 gewährleistet. Da die Flachteile 34 unmittelbar auf den Halbleiterschaltern 28 aufliegen, dienen diese nicht nur als elektrische Zuleitung sondern auch als Kühlkörper.

### Bezugszeichenliste

- 2: Substrat
- 4: Leiterschicht
- 6: Isolationsschicht
- 8: erste Kontaktpads
- 10: dritte Kontaktpads
- 12: fünfte Kontaktpads
- 14: Via
- 16: Trennstelle
- 18: Logikschaltung
- 20: zweite Kontaktpads
- 22: vierte Kontaktpads
- 24: sechste Kontaktpads
- 26: Schaltanschlüsse
- 28: Halbleiterschalter
- 30, 32: Kontaktpins
- 34: Flachteil

## Patentansprüche

1. Hochstromschaltung, insbesondere Kraftfahrzeughochstromschaltung, mit
- einer Leiterplatte aus einem nichtleitenden Substrat, einer auf dem Substrat aufgebrachten Leiterschicht und einer auf der Leiterschicht (4) aufgebrachten Isolationsschicht (6), wobei
- beidseitig der Leiterpatte jeweils die Isolationsschicht (6) durchbrechende Kontaktpads (8, 10, 12, 20, 22, 24) angeordnet sind, und die Kontaktpads (8, 10, 12, 20, 22, 24) über Vias (14) durch das Substrat (2) hindurch miteinander kontaktiert sind, und
- die Vias (14) in der Fläche der Kontaktpads (8, 10, 12, 20, 22, 24) angeordnet sind, wobei
- auf einer ersten Seite der Leiterplatte zumindest ein erstes der Kontaktpads (8) angeordnet ist und auf einer zweiten Seite der Leiterplatte mehrere Halbleiterschalter (28) unmittelbar mit zweiten Kontaktpads (20a-c) verbunden sind, und
- zumindest einer der Halbleiterschalter (28) mit dem ersten Kontaktpad (8) unmittelbar über die Vias (14) und das jeweilige zweite Kontaktpad (20a-c), ohne weitere Leiterbahnen, verbunden ist,
**dadurch gekennzeichnet,**
- **dass** jeweils einer der Halbleiterschalter (28) mit seinem Leistungsanschluss mit jeweils einem der zweiten Kontaktpads (20) verbunden ist,
- **dass** die zweiten Kontaktpads (20a-c) von Leistungsanschlüssen und Schaltanschlüssen der Halbleiterschalter (28) nebeneinander, zueinander isoliert auf der zweiten Seite der Leiterplatte angeordnet sind und
- **dass** auf der ersten Seite der Leiterplatte hierzu korrespondierend das erste Kontaktpad (8) vollflächig über die gesamte Fläche angeordnet ist, wobei
- die zweiten Kontaktpads (20a-c) auf der zweiten Seite der Leiterplatte über eine Vielzahl an Vias mit dem ersten Kontaktpad (8) auf der ersten Seite der Leiterplatte verbunden sind.

2. Hochstromschaltung nach Anspruch 1,
**dadurch gekennzeichnet,**
- **dass** die Flächen des ersten und zweiten Kontaktpads (8, 20a-c) auf den beiden Seiten der Leiterplatte übereinander angeordnet sind.

3. Hochstromschaltung nach Anspruch 1 oder 2,
**dadurch gekennzeichnet,**
- **dass** auf der ersten Seite der Leiterplatte ein Flachteil (34) unmittelbar mit dem ersten der Kontaktpad (8) verbunden ist.

4. Hochstromschaltung nach einem der vorangehenden Ansprüche,
**dadurch gekennzeichnet,**
- **dass** auf der zweiten Seite der Leiterplatte zumindest ein Kontaktpin (30, 32) des Halbleiterschalters (28) unmittelbar mit dem zweiten der Kontaktpads (20a-c) verbunden ist.

5. Hochstromschaltung einem der vorangehenden Ansprüche,
**dadurch gekennzeichnet,**
- **dass** auf der zweiten Seite der Leiterplatte zwei Halbleiterschalter (28) miteinander elektrisch in Reihe geschaltet sind, wobei ein viertes Kontaktpad (14) auf der zweiten Seite ohne weitere Leiterbahn eine elektrische Verbindung zwischen den miteinander elektrisch in Reihe geschaltet Halbleitern bildet und/oder
- **dass** auf der ersten Seite der Leiterplatte ein zweiter Halbleiterschalter (28) unmittelbar mit dem ersten Kontaktpad (8) verbunden ist.

6. Hochstromschaltung nach einem der vorangehenden Ansprüche,
**dadurch gekennzeichnet,**
- **dass** die Flächen des dritten und eines vierten Kontaktpads (10, 14) auf den beiden Seiten der Leiterplatte übereinander angeordnet sind.

7. Hochstromschaltung nach einem der vorangehenden Ansprüche,
**dadurch gekennzeichnet,**
- **dass** der erste und/oder zweite Halbleiterschalter (28) auf seiner einem der Kontaktpads (8, 10, 12, 20, 22, 24) abgewandten Seite unmittelbar mit einem Flachteil verbunden ist insbesondere dass der erste Halbleiterschalter (28) mit einer ersten breiten Oberfläche mit dem zweiten Kontaktpad (20a-c) verbunden sind und mit einer zweiten, der ersten Oberfläche gegenüberliegenden breiten Oberfläche mit einem ersten Flachteil verbunden ist und/oder der zweite Halbleiterschalter (28) mit einer ersten breiten Oberfläche mit dem ersten Kontaktpad (8) verbunden sind und mit einer zweiten, der ersten Oberfläche gegenüberliegenden breiten Oberfläche mit einem zweiten Flachteil verbunden ist.

8. Hochstromschaltung nach einem der vorangehenden Ansprüche,,
**dadurch gekennzeichnet,**
- **dass** das Flachteil unmittelbar auf der zweiten Oberfläche des Halbleiterschalters (28) angeordnet ist und/oder
- **dass** das Flachteil vollflächig mit dem zumindest einen Kontaktpad (8, 10, 12, 20, 22, 24) verbunden ist.

9. Hochstromschaltung nach einem der vorangehenden Ansprüche,
**dadurch gekennzeichnet,**
- **dass** die Halbleiterschalter (28) miteinander ausschließlich über die Vias (14) elektrisch verbunden sind und/oder
- **dass** die Anzahl der Vias (14) pro Kontaktpad eines Leistungsanschlusses zumindest zehn, bevorzugt mehr als dreißig ist.

10. Hochstromschaltung nach einem der vorangehenden Ansprüche,
**dadurch gekennzeichnet,**
- **dass** auf der ersten Seite ein Kontaktpad (8, 10, 12) eine Fläche hat, die zumindest die Fläche aller Anschlüsse des Halbleiterschalters (28) auf der zweiten Seite hat.

11. Hochstromschaltung nach einem der vorangehenden Ansprüche,
**dadurch gekennzeichnet,**
- **dass** auf der zweiten Seite ein Leistungsanschluss des Halbleiterschalters (28) unmittelbar mit dem Kontaktpad (20a-c, 22, 24) verbunden ist und ein Schaltanschluss (26) des Halbleiterschalters (28) mit einem Kontaktpad (26) und einer Leiterbahn verbunden ist.

12. Hochstromschaltung nach einem der vorangehenden Ansprüche,
**dadurch gekennzeichnet,**
- **dass** auf der ersten Seite zumindest drei voneinander isolierte Kontaktpads (8, 10, 12) angeordnet sind, wobei die Kontaktpads (8, 10, 12) jeweils über die Vias (14) mit Leistungsanschlüssen einer Mehrzahl von Halbleiterschaltern (28) verbunden sind und mit jedem der Kontaktpads (8, 10, 12) ein Flachteil (34) vollflächig verbunden ist.

13. Hochstromschaltung nach einem der vorangehenden Ansprüche,
**dadurch gekennzeichnet,**
- **dass** auf der zweiten Seite für jeweils einen Halbleiterschalter (28) zumindest ein Kontaktpad (20a-c, 22, 24) für jeweils einen von zwei Leistungsanschlüssen angeordnet ist und/oder
- **dass** auf der zweiten Seite Kontaktpads (20a-c, 22, 24) einer Mehrzahl an Leistungsanschlüssen einer Mehrzahl an Halbleiterschaltern (28) vollflächig miteinander verbunden sind.

14. Hochstromschaltung nach einem der vorangehenden Ansprüche,
**dadurch gekennzeichnet,**
- **dass** zumindest eines der Flachteile (34) aus der Fläche der Leiterplatte heraus geführt ist und eine Anschlussfahne für einen Energieleiter bildet.

15. Hochstromschaltung nach einem der vorangehenden Ansprüche,
**dadurch gekennzeichnet,**
- **dass** die Leiterschicht (24) zwischen zwei Kanten der Leiterplatte vollständig durchtrennt ist und die Leiterplatte in zwei Bereiche aufteilt, wobei in einem ersten Bereich eine Hochstromschaltung nach einem der vorangehenden Ansprüche angeordnet ist und in einem zweiten Bereich eine Logikschaltung angeordnet ist.

## Claims

1. High-current circuit, in particular motor vehicle high-current circuit, comprising
- a printed circuit board made from a non-conductive substrate, a conductor layer (4) applied to the substrate and an insulating layer (6) applied to the conductor layer, wherein
- contact pads (8, 10, 12, 20, 22, 24) which break through the insulation layer (6) are arranged on both sides of the conductor plate, and the contact pads (8, 10, 12, 20, 22, 24) are in contact with one another via vias (14) through the substrate (2), and
- the vias (14) are arranged in the area of the contact pads (8, 10, 12, 20, 22, 24), wherein
- at least a first one of the contact pads (8) is arranged on a first side of the printed circuit board and multiple semiconductor switches (28) are directly connected to second contact pads (20a-c) on a second side of the printed circuit board, and
- at least one semiconductor switch (28) is connected to the first contact pad (8) directly via the vias (14) and the respective second contact pad (20a-c), without further conductor tracks
**characterized in that**
- the respectively one of the semiconductor switches (28) is connected with a respective one of the second contact pads (20) with its power terminal,
- the second contact pads (20a-c) of power terminals and switching terminals of the semiconductor switches (28) are arranged on the second side of the printed circuit board isolated from each other and neighbouring each other and
- corresponding thereto on the first side of the printed circuit board the first contact pad (8) is arranged on the full entire surface, wherein
- the second contact pads (20a-c) on the second side of the printed circuit board are connected with the first contact pad (8) on the first side of the printed circuit board via a plurality of vias.

2. High current circuit according to claim 1,
**characterized in that**
- the areas of the first and second contact pads (8, 20a-c) are arranged one above the other on the two sides of the printed circuit board.

3. High-current circuit according to claim 1 or 2,
**characterized in that**
- on the first side of the printed circuit board a flat part (34) is directly connected to the first of the contact pads (8).

4. High-current circuit according to one of the preceding claims,
**characterized in that**
- on the second side of the printed circuit board at least one contact terminal (30, 32) of the semiconductor switch (28) is directly connected to the second of the contact pads (20a-c).

5. High current circuit according to any one of the preceding claims,
**characterized in that**
- two semiconductor switches (28) are electrically connected in series with one another on the second side of the printed circuit board, wherein a fourth contact pad (14) on the second side forming an electrical connection between the semiconductors electrically connected in series with one another without a further conductor track, and/or
- on the first side of the printed circuit board a second semiconductor switch (28) is directly connected with the first contact pad (8).

6. High current circuit according to any one of the preceding claims,
**characterized in that**
- **in that** the areas of the third and a fourth contact pad (10, 14) on the two sides of the printed circuit board are arranged one above the other.

7. High-current circuit according to any one of the preceding claims,
**characterized in that**
- the first and/or second semiconductor switch (28) is directly connected to a flat part on its side facing away from one of the contact pads (8, 10, 12, 20, 22, 24), in particular **in that** the first semiconductor switch (28) is connected to the second contact pad (20a-c) by means of a first wide surface and is connected to a first flat part by means of a second wide surface opposite the first surface, and/or the second semiconductor switch (28) is connected to the first contact pad (8) by means of a first wide surface and is connected to a second flat part by means of a second wide surface opposite the first surface.

8. High current circuit according to any one of the preceding claims,
**characterized in that**
- the flat part is arranged directly on the second surface of the semiconductor switch (28) and/or
- the flat part is connected with at least one contact pad (8, 10, 12, 20, 22, 24) over the entire surface.

9. High current circuit according to any one of the preceding claims,
**characterized in that**
- the semiconductor switches (28) are electrically connected to one another exclusively via the vias (14) and/or
- the number of vias (14) per contact pad of a power terminal is at least ten, preferably more than thirty.

10. High-current circuit according to any one of the preceding claims,
**characterized in that**
- a contact pad (8, 10, 12) on the first side has an area which is at least equal to the area of all the terminals of the semiconductor switches (28) on the second side.

11. High current circuit according to any one of the preceding claims,
**characterized in that**
- on the second side a power terminal of the semiconductor switch (28) is directly connected to the contact pad (20a-c, 22, 24) and a switching terminal (26) of the semiconductor switch (28) is connected to a contact pad (26) and a conductor track.

12. High-current circuit according to any one of the preceding claims,
**characterized in that**
- at least three contact pads (8, 10, 12) which are insulated from one another are arranged on the first side, the contact pads (8, 10, 12) each being connected via the vias (14) to power terminals of a plurality of semiconductor switches (28), and a flat part (34) being connected to each of the contact pads (8, 10, 12) over the entire surface.

13. High-current circuit according to any one of the preceding claims,
**characterized in that**
- at least one contact pad (20a-c, 22, 24) for each respective one of two power terminals is arranged on the second side for each respective one semiconductor switch (28) and/or
- contact pads (20a-c, 22, 24) of a plurality of power terminals of a plurality of semiconductor switches (28) are connected to one another over their entire surface on the second side.

14. High-current circuit according to any one of the preceding claims,
**characterized in that**
- at least one of the flat parts (34) is led out of the surface of the printed circuit board and forms a terminal lug for a power conductor.

15. High-current circuit according to any one of the preceding claims,
**characterized in that**
- the conductor layer (24) between two edges of the printed circuit board is completely cut through and divides the printed circuit board into two regions, a high-current circuit according to one of the preceding claims being arranged in a first region and a logic circuit being arranged in a second region.

## Revendications

1. Circuit à courant élevé, en particulier circuit à courant élevé pour véhicule automobile, avec
- une plaque à circuit imprimé composée d'un substrat non conducteur, d'une couche conductrice appliquée sur le substrat et d'une couche isolante appliquée sur la couche conductrice (4), où
- des patins de contact (8, 10, 12, 20, 22, 24) traversant respectivement la couche isolante (6) sont disposés des deux côtés de la plaque conductrice, et les patins de contact (8, 10, 12, 20, 22, 24) sont mis en contact les uns avec les autres à travers le substrat (2) par l'intermédiaire de vias (14), et
- les vias (14) sont disposés dans la surface des patins de contact (8, 10, 12, 20, 22, 24), où,
- sur un premier côté de la plaque à circuit imprimé, au moins un premier des patins de contact (8) est disposé et, sur un deuxième côté de la plaque à circuit imprimé, plusieurs commutateurs à semi-conducteur (28) sont directement reliés à des deuxièmes patins de contact (20a-c) et
- au moins un des commutateurs à semi-conducteur (28) est relié au premier patin de contact (8) directement par l'intermédiaire des vias (14) et au deuxième patin de contact (20a-c) respectif, sans autres pistes conductrices,
**caractérisé**
- **en ce que**, respectivement, un des commutateurs à semi-conducteur (28) est relié respectivement, par son raccordement de puissance, à l'un des deuxièmes patins de contact (20),
- **en ce que** les deuxièmes patins de contact (20a-c) de raccordements de puissance et de raccordements de commutation des commutateurs à semi-conducteur (28) sont disposés les uns à côté des autres, isolés les unes des autres sur le deuxième côté de la plaque à circuit imprimé et
- **en ce que**, sur le premier côté de la plaque à circuit imprimé, en correspondance, le premier patin de contact (8) est disposé de manière surfacique sur toute la surface, où
- les deuxièmes patins de contact (20a-c) sur le deuxième côté de la plaque à circuit imprimé sont reliés par une série de vias avec le premier patin de contact (8) sur le premier côté de la plaque à circuit imprimé.

2. Circuit à courant élevé selon la revendication 1,
**caractérisé**
**en ce que** les surfaces du premier et du deuxième patin de contact (8, 20a-c) sont superposées sur les deux côtés de la plaque à circuit imprimé.

3. Circuit à courant élevé selon la revendication 1 ou 2,
**caractérisé**
**en ce que**, sur le premier côté de la plaque à circuit imprimé, une élément plat (34) est directement relié au premier des patins de contact (8).

4. Circuit à courant élevé selon l'une des revendications précédentes,
**caractérisé**
**en ce que**, sur le deuxième côté de la plaque à circuit imprimé, au moins un patin de contact (30, 32) du commutateur à semi-conducteur (28) est directement relié au deuxième des patins de contact (20a-c).

5. Circuit à courant élevé selon l'une des revendications précédentes,
**caractérisé**
- **en ce que**, sur le deuxième côté de la plaque à circuit imprimé, deux commutateurs à semi-conducteur (28) sont connectés électriquement en série l'un avec l'autre, où un quatrième patin de contact (14) forme, sur le deuxième côté, sans autre piste conductrice, une connexion électrique entre les semiconducteurs connectés électriquement en série
et / ou
- **en ce que**, sur le premier côté de la plaque à circuit imprimé, un deuxième commutateur à semi-conducteur (28) est directement relié au premier patin de contact (8).

6. Circuit à courant élevé selon l'une des revendications précédentes,
**caractérisé**
**en ce que** les surfaces du troisième et d'un quatrième patin de contact (10, 14) sont superposées sur les deux côtés de la plaque à circuit imprimé.

7. Circuit à courant élevé selon l'une des revendications précédentes,
**caractérisé**
- **en ce que** le premier et/ou le deuxième commutateur à semi-conducteur (28) est relié, par son côté opposé à l'un des patins de contact (8, 10, 12, 20, 22, 24), directement à un élément plat,
- en particulier en ce que le premier commutateur à semi-conducteur (28) est relié, par une première surface large, avec le deuxième patin de contact (20a-c) et, par une deuxième surface large opposée à la première surface, avec un premier élément plat,
et/ou le deuxième commutateur à semi-conducteur (28) est relié, par une première surface large, au premier patin de contact (8) et, par une deuxième surface large opposée à la première surface, à une deuxième élément plat.

8. Circuit à courant élevé selon l'une des revendications précédentes,
**caractérisé**
- **en ce que** l'élément plat est disposé directement sur la deuxième surface du commutateur à semi-conducteur (28)
et/ou
- **en ce que** l'élément plat est relié sur toute sa surface à l'au moins un patin de contact (8, 10, 12, 20, 22, 24).

9. Circuit à courant élevé selon l'une des revendications précédentes,
**caractérisé**
- **en ce que** les commutateurs à semi-conducteur (28) sont reliés électriquement entre eux exclusivement par les vias (14)
et/ou
- **en ce que** le nombre de vias (14) par patin de contact d'un raccordement de puissance est d'au moins dix, de préférence de plus de trente.

10. Circuit à courant élevé selon l'une des revendications précédentes,
**caractérisé**
**en ce que** sur le premier côté, un patin de contact (8, 10, 12) a une surface qui a au moins la surface de toutes les raccordements du commutateur à semi-conducteur (28) sur le deuxième côté.

11. Circuit à courant élevé selon l'une quelconque des revendications précédentes,
**caractérisé**
- **en ce que** sur le deuxième côté, un raccordement de puissance du commutateur à semi-conducteur (28) est directement relié au patin de contact (20a-c, 22, 24) et qu'un raccordement de commutation (26) du commutateur à semi-conducteur (28) est relié à un patin de contact (26) et à une piste conductrice.

12. Circuit à courant élevé selon l'une des revendications précédentes,
**caractérisé**
- **en ce que**, sur le premier côté, au moins trois patins de contact (8, 10, 12) isolés les unes des autre sont disposés, les patins de contact (8, 10, 12) étant reliés respectivement par l'intermédiaire des vias (14) à des raccordements de puissance d'une pluralité de commutateurs à semi-conducteur (28), et un élément plat (34) étant relié sur toute sa surface à chacun des patins de contact (8, 10, 12).

13. Circuit à courant élevé selon l'une des revendications précédentes,
**caractérisé**
- **en ce que**, sur le deuxième côté, pour respectivement un commutateur à semi-conducteur (28), au moins un patin de contact (20a-c, 22, 24) est disposé pour respectivement l'un parmi deux raccordements de puissance et/ou
- **en ce que** sur le deuxième côté, des patins de contact (20a-c, 22, 24) d'une pluralité de raccordements de puissance d'une pluralité de commutateurs à semi-conducteur (28) sont reliés entre eux sur toute leur surface.

14. Circuit à courant élevé selon l'une quelconque des revendications précédentes,
**caractérisé**
- **en ce qu'**au moins un des éléments plat (34) sort de la surface de la plaque à circuit imprimé et forme une languette de raccordement pour un conducteur d'énergie.

15. Circuit à courant élevé selon l'une des revendications précédentes,
**caractérisé**
- **en ce que** la couche conductrice (24) est entièrement sectionnée entre deux bords de la plaque à circuit imprimé et divise la plaque à circuit imprimé en deux zones, où, dans une première zone, un circuit à courant élevé selon l'une des revendications précédentes est disposé et, dans une deuxième zone, un circuit logique est disposé.
